# EUROPEAN PATENT APPLICATION

(11) **EP 2 254 194 A1**
(43) Date of publication of application: **24.11.2010**
(21) Application number: 09714888.6
(22) Date of filing: 23.02.2009
(51) Int. Cl.: H01M 14/00, H01L 31/04

(54) **OPPOSING ELECTRODE AND PHOTOELECTRIC CONVERSION ELEMENT USING THE OPPOSING ELECTRODE**

(30) Priority: 25.02.2008 JP 2008042660
(71) Applicant: FUJIKURA LTD., Kohtoh-ku Tokyo 135-0042 (JP)
(72) Inventor: USUI, Hiroki, Sakura-shi Chiba 285-8550 (JP)
(74) Representative: HOFFMANN EITLE
(86) International application number: PCT/JP2009/000754
(87) International publication number: WO 2009/107348

(57) **Abstract**

The present invention provides a counter electrode that is excellent in photoelectric conversion efficiency and may achieve a photoelectric conversion element where a short circuit between a working electrode and a counter electrode hardly occurs, and a photoelectric conversion element including the counter electrode. The present invention is a counter electrode that includes an intermediate layer made of porous carbon, and an insulating separator that is disposed on one surface of the intermediate layer. The porous carbon includes a plurality of carbon nanotubes.

## Description

### TECHINCAL FIELD

The present invention relates to a counter electrode used in a photoelectric conversion element and a photoelectric conversion element including the counter electrode.

### BACKGROUND ART

A dye-sensitized solar cell is developed by Gratzel, et al., (Swiss), has advantages of high photoelectric conversion efficiency and low manufacturing cost, and attracts attention as a new type solar cell.

The dye-sensitized solar cell generally includes a working electrode and a counter electrode that is disposed so as to face the working electrode. The working electrode is made of oxide semiconductor fine particles (nanoparticles) such as a titanium dioxide on a transparent conductive electrode substrate, and includes a porous layer on which a photosensitizing element is supported. A gap between the working electrode and the counter electrode is filled with an electrolyte containing redox pairs.

In this kind of dye-sensitized solar cell, electrons are injected to the oxide semiconductor fine particles by a photosensitization dye absorbing incident light such as sunlight or the like, so that an electromotive force is generated between the working electrode and the counter electrode. Thus, the dye-sensitized solar cell functions as a photoelectric conversion element that converts light energy into electrical power.

An electrolyte solution, which is obtained by dissolving redox pairs such as I⁻/I³⁻ or the like in an organic solvent such as acetonitrile or the like, is generally used as the electrolyte. In addition to this, there are known an electrolyte that uses nonvolatile ionic liquid, an electrolyte that is pseudo-solidified by making a liquid electrolyte gel by an appropriate gelling agent, and an electrolyte that uses a solid semiconductor such as a p-type semiconductor or the like. A conductive glass electrode substrate on which platinum is mainly supported, a metal substrate, or porous carbon is used as the counter electrode.

The carbon electrode has a porous structure in order to increase electrical conductivity. For example, in Patent Document 1, an electrode containing a carbon black, a columnar conductive carbon material and a titanium oxide or conductive oxide are used in order to manufacture a porous carbon electrode.

However, since a titanium oxide or a conductive oxide is contained in the carbon electrode, there has been a concern that the electrical conductivity of the carbon electrode is lowered.

Further, since a porous layer made of a titanium oxide is provided between the working electrode and the counter electrode in order to prevent a short circuit, a baking process performed at high temperature has been required in order to obtain the porous layer. In thisbaking process performed at high temperature, there has been a concern that a photoelectric conversion element to be obtained is damaged and photoelectric conversion efficiency deteriorates.
Patent Document 1: Japanese Patent Application Laid-Open (JP-A) No. 2004-152747

### DISCLOSURE OF THE INVENTION

### PROBLEM TO BE SOLVED BY THE INVENTION

An object of the present invention is to provide a counter electrode that is excellent in photoelectric conversion efficiency and may achieve a photoelectric conversion element where a short circuit between a working electrode and a counter electrode hardly occurs, and a photoelectric conversion element including the counter electrode.

### MEANS FOR SOLVING THE PROBLEM

The present invention provides a counter electrode that comprises an intermediate layer comprising porous carbon and an insulating separator which is disposed on one surface of the intermediate layer, weherein the porous carbon includes a plurality of carbon nanotubes.

According to the counter electrode of the present invention, it is possible to obtain an inexpensive counter electrode that is excellent in electrical conductivity by using the intermediate layer comprising porous carbon including carbon nanotubes. Further, it is possible to suppress a short circuit, which is caused by direct contact between the counter electrode and another electrode, that is, a working electrode, by the insulating separator that is disposed on the surface layer of the intermediate layer like a film. Accordingly, according to the counter electrode of the present invention, a photoelectric conversion element can be assembled by interposing an electrolyte between the counter electrode and the working electrode like in the related art except for the addition of the separator. Accordingly, electrical conductivity is improved, cost is reduced, and connection reliability is also improved.

The above counter electrode may be used as a counter electrode of a photoelectric conversion element that includes at least a counter electrode, a working electrode disposed so as to face the counter electrode and including an oxide semiconductor porous layer on which a sensitized dye is supported, and an electrolyte that is disposed in at least a part of a gap between the counter electrode and the working electrode.

In the above counter electrode, the intermediate layer is preferably partially exposed through the separator. In this case, it is possible to achieve a photoelectric conversion element that has more excellent photoelectric conversion efficiency.

The counter electrode may further include a substrate, and the above intermediate layer may be disposed on one surface of the substrate.

In the above counter electrode, the respective longitudinal directions of the plurality of carbon nanotubes is preferably substantially parallel to one surface of the substrate. In this case, it is possible to more sufficiently suppress a short circuit with the working electrode included in the photoelectric conversion element, as compared to a case where the respective longitudinal directions of the plurality of carbon nanotubes are perpendicular to one surface of the substrate facing the intermediate layer or the like.

In the above counter electrode, the separator preferably includes a polytetrafluoroethylene copolymer. A polytetrafluoroethylene copolymer is chemically stable, and has high chemical resistance, high heat resistance, and a high electrical insulating property. Accordingly, if a polytetrafluoroethylene copolymer is used as the separator coming into contact with an electrolyte solution, it is possible to effectively suppress a short circuit with the working electrode of the photoelectric conversion element.

In the above counter electrode, specifically, the carbon nanotube may be a single-layer carbon nanotube and/or a multilayer carbon nanotube.

Further, the present invention provides a photoelectric conversion element comprising at least the above counter electrode, a working electrode that is disposed so as to face the counter electrode, and includes an oxide semiconductor porous layer on which a sensitized dye is supported, and an electrolyte that is disposed in at least a part of a gap between the counter electrode and the working electrode, wherein the separator is disposed between the intermediate layer of the counter electrode and the electrolyte.

According to the photoelectric conversion element of the present invention, since the insulating separator is disposed on the surface layer of the intermediate layer containing carbon nanotubes like a film, it is possible to suppress a short circuit between the counter electrode including a porous carbon layer and the working electrode. Furthermore, since the counter electrode, which is excellent in electrical conductivity, is provided, it is possible to provide a photoelectric conversion element that is excellent in photoelectric conversion efficiency.

### EFFECT OF THE INVENTION

According to the counter electrode of the present invention, it is possible to obtain an inexpensive counter electrode that is excellent in electrical conductivity by using the intermediate layer comprising porous carbon including carbon nanotubes. Further, it is possible to suppress a short circuit, which is caused by direct contact between the counter electrode and another electrode, that is, a working electrode, by the insulating separator that is disposed on the surface layer of the intermediate layer like a film. Accordingly, a photoelectric conversion element may be assembled by interposing an electrolyte between the counter electrode and the working electrode like in the related art except for the addition of the separator. Accordingly, it is possible to obtain a counter electrode for a photoelectric conversion element that improves electrical conductivity, reduces cost, and improves connection reliability. As a result, it is possible to achieve a photoelectric conversion element that is excellent in photoelectric conversion efficiency and hardly generates a short circuit between the working electrode and the counter electrode.

According to the photoelectric conversion element of the present invention, since the insulating separator is disposed on the surface layer of the intermediate layer including carbon nanotubes like a film, it is possible to suppress a short circuit between the counter electrode including the porous carbon layer and the working electrode. Further, since the counter electrode, which is excellent in electrical conductivity, is provided, it is possible to provide a photoelectric conversion element that is excellent in photoelectric conversion efficiency.

### BRIER DESCRIPTION OF THE DRAWINGS

Fig. 1 is a cross-sectional view illustrating an embodiment of a counter electrode according to the present invention.
Fig. 2 is a plan view illustrating the counter electrode illustrated in Fig. 1.
Fig. 3 is an enlarged view of α in Fig. 2.
Fig. 4 is a cross-sectional view taken along a line M-M of Fig. 3.
Fig. 5 is a cross-sectional view schematically illustrating a photoelectric conversion element including the counter electrode according to the present invention.

### REFERENCE NUMERALS

- 10: counter electrode
- 11: substrate
- 11a: one surface of substrate
- 12: intermediate layer
- 12a: one surface of intermediate layer
- 13: carbon nanotube
- 20: working electrode
- 21: base material
- 22: transparent conductive film
- 23: porous oxide semiconductor layer
- 30: electrolyte
- 40: sealing member
- 50: photoelectric conversion element

### BEST MODE FOR CARRYING OUT THE INVENTION

The present invention will be described in detail below with reference to drawings. However, the present invention is not limited thereto, and may have various modifications without departing from the scope of the present invention.

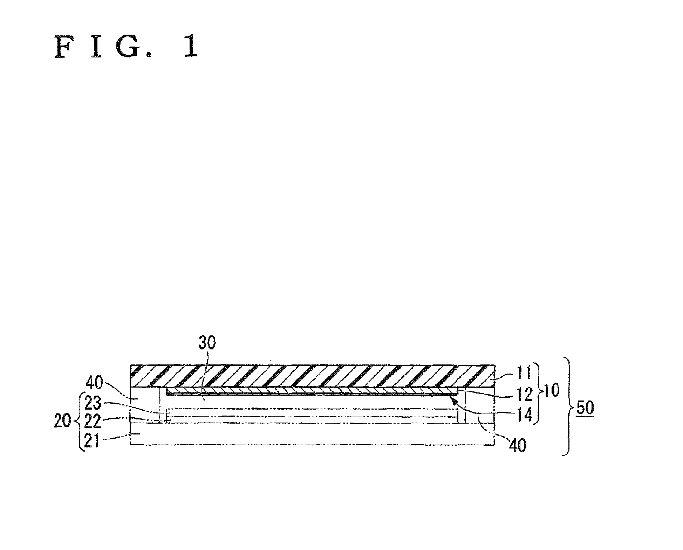

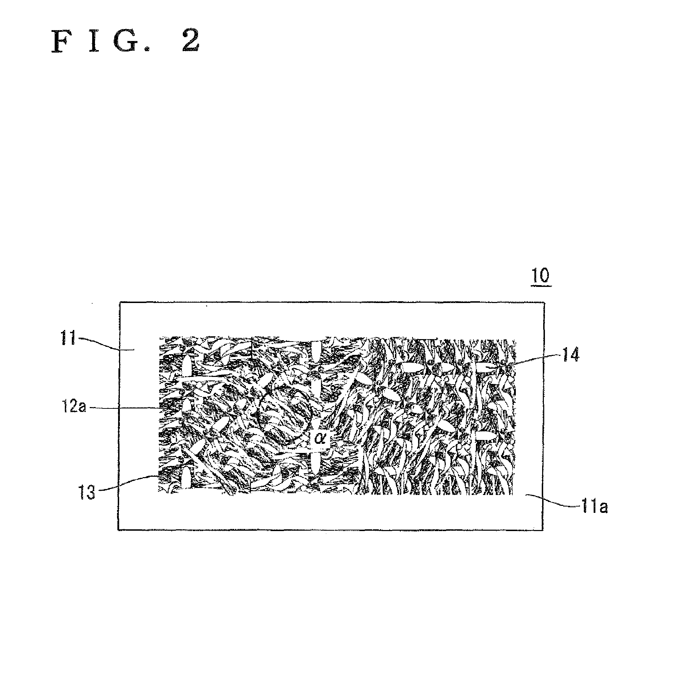

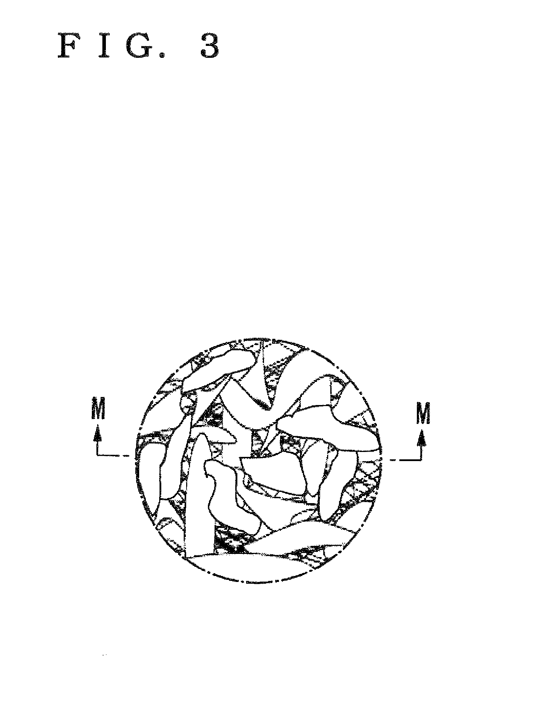

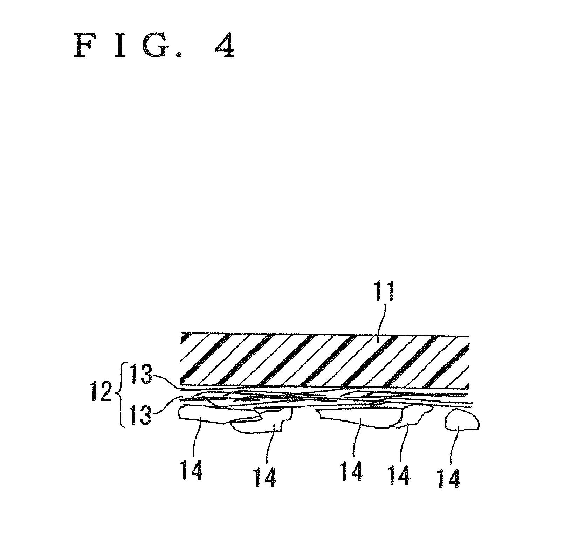

Fig. 1 is a cross-sectional view illustrating an embodiment of a counter electrode according to the present invention, Fig. 2 is a schematic plan view illustrating the counter electrode illustrated in Fig. 1, Fig. 3 is an enlarged view of α in Fig. 2, and Fig. 4 is a cross-sectional view taken along a line M-M of Fig. 3. As illustrated in Figs. 1 to 4, a counter electrode 10 generally includes a substrate 11; an intermediate layer 12 that comprises porous carbon and is disposed on one surface 11a of the substrate 11; and an insulating separator 14 that is disposed on a surface layer of the intermediate layer 12, that is, one surface 12a of the intermediate layer. The intermediate layer 12 includes a plurality of carbon nanotubes 13, and the respective carbon nanotubes 13 are disposed so that the longitudinal directions of the carbon nanotubes are mixed to be substantially parallel to one surface 11a of the substrate 11. Further, the intermediate layer 12 is partially or locally exposed through the separator 14. Here, it is preferable that the separator 14 directly comes into contact with one surface 12a of the intermediate layer 12 since foreign materials are difficult to enter the intermediate layer or electrical conductivity of the intermediate layer 12 does not deteriorate. However, a layer such as an adhesive material (for example, an adhesive resin) or the like may be disposed between the separator 14 and the intermediate layer 12.

Thus, the counter electrode 10 includes the intermediate layer 12 containing the carbon nanotubes. Accordingly, the counter electrode 10 is inexpensive and excellent in electrical conductivity. Further, it is possible to suppress a short circuit, which is caused by direct contact between the counter electrode 10 and another electrode, that is, a working electrode 20, by the insulating separator 14 that is disposed on the surface layer of the intermediate layer 12 like a film. Accordingly, according to the counter electrode 10, if a photoelectric conversion element 50 is assembled by interposing an electrolyte between the counter electrode 10 and the working electrode 20 like in the related art except for the addition of the separator 14, electrical conductivity is improved, cost is reduced, and connection reliability is also improved. As a result, it is possible to obtain the photoelectric conversion element 50 that is excellent in photoelectric conversion efficiency and hardly causes a short circuit between the working electrode 20 and the counter electrode 10.

The substrate 11 may be a substrate that is formed of an electric conductor in itself like, for example, a titanium substrate, and may be a substrate that has a conductive film formed on the surface of an insulating substrate, like, for example, a FTO glass substrate.

The intermediate layer 12 comprises porous carbon. Here, the specific surface area of porous carbon caused by the BET method is usually in the range of 10 to 2000 m²/g, and preferably in the range of 50 to 1000 m²/g. Although the thickness of the intermediate layer 12 may be appropriately adjusted in consideration of required electrical conductivity, the thickness of the intermediate layer is in the range of, for example, 5 µm to 100 µm. The porous carbon is formed of a plurality of carbon nanotubes 13. The carbon nanotubes 13 are disposed so that the longitudinal directions of the carbon nanotubes are substantially parallel to one surface 11a of the substrate 11 or one surface 12a of the intermediate layer 12. For this reason, it is possible to more sufficiently suppress a short circuit with the working electrode 20 included in the photoelectric conversion element 50, as compared to a case where the respective longitudinal directions of the plurality of carbon nanotubes 13 are perpendicular to one surface 11a of the substrate 11 facing the intermediate layer 12 or one surface 12a of the intermediate layer 12 or the like. In addition, the carbon nanotubes 13 are disposed so that the longitudinal directions of the carbon nanotubes are substantially parallel to one surface 11a of the substrate 11 or one surface 12a of the intermediate layer 12, and the carbon nanotubes are randomly mixed. That is, the longitudinal directions of the carbon nanotubes are directed to various directions within one surface 11a of the substrate 11 and the carbon nanotubes are mixed.

The carbon nanotube 13 has a cylindrical structure which is obtained by forming one layer (graphene sheet), which is made of graphite including connected six-membered carbon rings, in the shape of a cylinder or a frustum of a cone. Further, the carbon nanotube is a material that has a diameter of about 0.7 to 50 nm, a length of several micrometers, hollow structure, and a very large aspect ratio. Here, the aspect ratio is represented by a ratio of length to diameter. The aspect ratio is preferably in the range of 10 to 20000 and more preferably in the range of 100 to 10000. If the aspect ratio is less than 10, a specific surface area tends to decrease. If the aspect ratio exceeds 20000, the carbon nanotube 13 is apt to protrude from the separator 14.

The carbon nanotube 13 exhibits from a metal property to a semiconductor property depending on diameter or chirality as an electrical property, and has both a large Young's modulus and a property capable of relieving stress by buckling as a mechanical property. Further, since not having a dangling bond, the carbon nanotube 13 is chemically stable. Furthermore, since being synthesized from inexpensive hydrocarbon, the carbon nanotube may be mass-produced and the manufacturing cost of the carbon nanotube may be reduced.

Porous carbon may include carbon nanotubes. Accordingly, porous carbon may be formed of a plurality of single-layer carbon nanotubes or may be formed of a plurality of multilayer carbon nanotubes. Further, porous carbon may be formed of a mixture of a plurality of single-layer carbon nanotubes and a plurality of multilayer carbon nanotubes. When a mixture of single-layer carbon nanotubes and multilayer carbon nanotubes is used, a mixing ratio is not particularly limited. The single-layer carbon nanotubes and multilayer carbon nanotubes may be mixed in consideration of a photoelectric conversion element to be applied, photoelectric conversion efficiency, or the like while the mixing ratios are appropriately adjusted.

If the carbon nanotube 13 is consisting of a single layer, that is, the graphene sheet is consisting of one layer, the diameter of the carbon tube 13 is in the range of, for example, 0.5 nm to 10 nm and the length of the carbon nanotube is in the range of, for example, 10 nm to 1 µm.

If the carbon nanotube 13 is consisting of multiple layers, that is, graphene sheet is consisting of multiple layers, the diameter of the carbon nanotube 13 is in the range of, for example, 1 nm to 100 nm and the length of the carbon nanotube is in the range of, for example, 50 nm to 50 µm.

The carbon nanotube 13 may be manufactured by a well-known method. For example, chemical vapor deposition method (CVD), an arc method, a laser ablation method or the like may be used as the method.

As described in, for example, Japanese Patent Application Laid-Open (JP-A) No. 2001-220674, after being formed on one surface 11a of the substrate 11 by sputtering or depositing metal, such as nickel, cobalt, iron or the like, a film is heated for 1 to 60 minutes in an inert atmosphere, a hydrogen atmosphere, or vacuum at a temperature of preferably 500 to 900°C. After that, a film is formed by general chemical vapor deposition method (CVD) while hydrocarbon gas such as acethylene, ethylene or the like, or alcohol gas is used as a raw material. Accordingly, it is possible to grow a carbon nanotube, which has a diameter of 5 to 75 nm and a length of 0.1 to 500 µm, on the substrate 11.

It is possible to control the length or size (diameter) of the carbon nanotube by controlling, for example, temperature or time when the carbon nanotube is formed by CVD method.

Preferable is the carbon nanotube having a diameter of about 0.5 to 100 nm and a length of about 10 nm to 50 µm be used as the carbon nanotube 13 used in the present invention.

As illustrated in Figs. 3 and 4, the insulating separator 14 is disposed in a statelike a film, which covers a plurality of carbon nanotubes 11, on one surface 12a side of the intermediate layer 12 that comes into contact with an electrolyte. Further, the intermediate layer 12 is disposed so as to be partially or locally exposed through the separator 14. The separator 14 suppresses the generation of a short circuit that is caused by the contact between the counter electrode 10 according to the present invention and the working electrode 20.

It is preferable that the separator 14 comprise a polytetrafluoroethylene copolymer that is chemically stable and has high chemical resistance, high heat resistance, and a high electrical insulating property. A polytetrafluoroethylene copolymer is chemically stable, and has high chemical resistance, high heat resistance, and a high electrical insulating property. Accordingly, if a polytetrafluoroethylene copolymer is used as the separator coming into contact with an electrolyte solution 30, it is possible to effectively suppress a short circuit with the working electrode 20 of the photoelectric conversion element 50. A product on the market may be used as the polytetrafluoroethylene copolymer, and examples of the polytetrafluoroethylene copolymer include, for example, materials, which are sold as trade names, such as Polyflon, Teflon (registered trademark), Fluron, Halon, Hostaflon and the like.

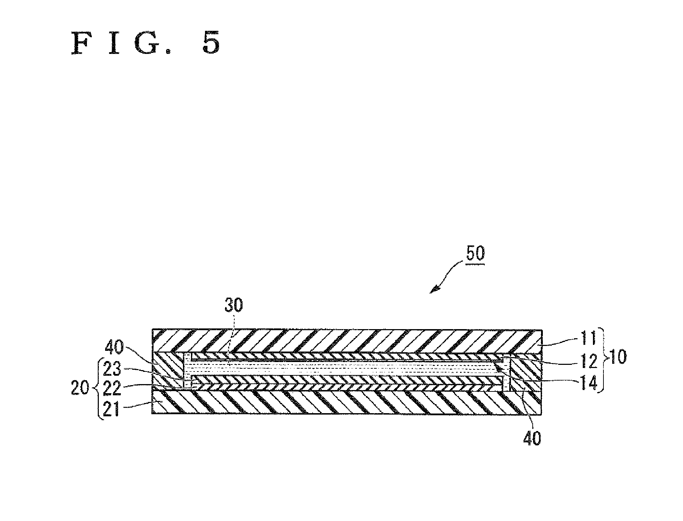

Fig. 5 is a cross-sectional view schematically illustrating the photoelectric conversion element 50 including the counter electrode 10 of the present invention. The photoelectric conversion element 50 generally includes the counter electrode 10, the working electrode 20, and the electrolyte 30. The counter electrode 10 includes the substrate 11 and the intermediate layer 12 that is disposed on one surface 11a of the substrate and is made of porous carbon. The working electrode 20 is disposed so as to face the intermediate layer 12 and includes a semiconductor porous layer 23 where a sensitized dye is supported. The electrolyte 30 is disposed in at least a part of a gap between the counter electrode 10 and the working electrode 20. Further, the outer peripheral portions of a laminated body, which is formed by interposing the electrolyte 30 between the working electrode 20 and the counter electrode 10, are adhered to each other by a sealing member 40 and integrated. As a result, the photoelectric conversion element 50 is formed.

The separator 14 is disposed on one surface 12a side of the intermediate layer 12 that comes into contact with the electrolyte 30. Accordingly, a short circuit, which is caused by the contact between the counter electrode 10 and the working electrode 20, is suppressed. If a distance between the working electrode 20 and the counter electrode 10 increases, an electrical resistance component in a solution in a cell increases and electric power generation characteristics of the cell deteriorate. For this reason, the thickness of the separator 14 is preferably in the range of 0.1 µm to 50 µm, and more preferably in the range of 1 µm to 20 µm. Accordingly, it is possible to obtain the photoelectric conversion element 50 that has a further suppressed short circuit between the working electrode 20 and the counter electrode 10 and is excellent in photoelectric conversion efficiency.

The working electrode 20 generally includes a base material 21, a transparent conductive film 22 that is formed on a principal surface of the base material, and a semiconductor porous layer 23 where a sensitized dye is supported.

A substrate made of an optically-transparent material is used as the base material 21, and any one of materials, which may be usually used as a transparent base material of the photoelectric conversion element, such as glass, polyethylene terephthalate, polycarbonate, polyethersulfone or the like, may be used. The base material 21 is appropriately selected from these materials in consideration of a tolerance to the electrolyte solution. Further, preferable is a substrate, which is excellent in optical transparency as much as possible as the base material 21 in terms of use application. A substrate having a transmittance of 90% or more is more preferable as the base material.

The transparent conductive film 22 is a thin film that is formed on one surface of the base material 21 so as to make the base material have electrical conductivity. To not significantly impair transparency, it is preferable that the transparent conductive film 22 be a thin film made of a conductive metal oxide.

For example, a tin-doped indium oxide (ITO), a fluorine-doped tin oxide (FTO), a tin oxide (SnO₂) or the like is used as the conductive metal oxide that forms the transparent conductive film 22. An ITO or a FTO among the oxides is preferable in terms of easiness in forming a film and low manufacturing cost. Further, it is preferable that the transparent conductive film 22 be a single film made of only an ITO or be a laminated film formed by laminating a film made of a FTO on a film made of an ITO.

If the transparent conductive film 22 is a single film made of only an FTO or a laminated film formed by laminating a film made of a FTO on a film made of an ITO, it is possible to form a transparent conductive substrate that has a small amount of absorbed light in a visible range and high electrical conductivity.

The porous oxide semiconductor layer 23 is provided on the transparent conductive film 22, and a sensitized dye is supported on the surface of the porous oxide semiconductor layer. A semiconductor, which forms the porous oxide semiconductor layer 22, is not particularly limited, and any one of materials, which may be usually used to form a porous oxide semiconductor for the photoelectric conversion element, may be used. For example, a titanium oxide (TiO₂), a tin oxide (SnO₂), a tungsten oxide (WO₃), a zinc oxide (ZnO), a niobium oxide (Nb₂O₅) or the like may be used as the semiconductor.

As a method of forming the porous oxide semiconductor layer 23, there may be used a method including adding a desired additive to dispersion liquid that is obtained by dispersing, for example, commercial oxide semiconductor fine particles in a desired dispersion medium, or a colloid solution that can be prepared by a sol-gel method, according to need; applying a mixture by well-known coating such as screen printing, inkjet printing, roll coating, a doctor blade method, spray coating or the like; and making the mixture be porous by forming voids by removing the polymer microbeads with heating processing or chemical processing.

A ruthenium complex where a bipyridine structure, a terpyridine structure, or the like is included in ligands; a metal-containing complex, such as porphyrin, phthalocyanine or the like; and an organic dye, such as eosin, rhodamine, merocyanine or the like may be applied as the sensitized dye. A material, which exhibits behavior suitable for use application and a semiconductor to be used, may be selected from them without particular limitation.

As the electrolyte 30, there is used an electrolyte that is obtained by impregnating the porous oxide semiconductor layer 23 with an electrolyte solution; an electrolyte that is formed integrally with the porous oxide semiconductor layer 23 by impregnating the porous oxide semiconductor layer 23 with an electrolyte solution and then making the electrolyte solution gel (be pseudo-solidified) using an appropriate gelling agent; or a gelatinous electrolyte containing ionic liquid, oxide semiconductor particles, and conductive particles.

As the electrolyte solution, there is used a solution, which is obtained by dissolving electrolyte components, such as iodine, iodide ions, tertiary butylpyridine or the like, in an organic solvent, such as ethylene carbonate, methoxyacetonitrile or the like.

Examples of a gelling agent that is used to make the electrolyte solution gel include polyvinylidene fluoride, a polyethylene oxide derivative, an amino-acid derivative, and the like.

The ionic liquid is not particularly limited. Examples of the ionic liquid include room temperature molten salt which is liquid at room temperature and of which cations or anions are a compound including quaternized nitrogen atoms.

Examples of the cation of the room temperature molten salt include a quaternized imidazolium derivative, a quaternized pyridinium derivative, a quaternized ammonium derivative, and the like.

Examples of the anion of the room temperature molten salt include BF₄⁻, PF₆⁻, F(HF)ₙ⁻, bis(trifluoromethylsulfanyl)imide [N(CF₃SO₂)₂⁻] iodide ions, and the like.

Specific examples of the ionic liquid include salt that includes quaternized imidazolium-based cations and iodide ions, bis(trifluoromethylsulfonyl)imide ions or the like.

The kind, particle size, or the like of a material of the oxide semiconductor particle is not particularly limited. However, as the material of the oxide semiconductor particle, there is used a material that is excellently miscible in the electrolyte solution containing ionic liquid as a main material and makes the electrolyte solution gel. Further, it is necessary that the oxide semiconductor particle does not cause the deterioration of the semiconductivity of the electrolyte and has excellent chemical stability against other accompanying components contained in the electrolyte. In particular, preferable is the oxide semiconductor particle that does not cause the degradation due to an oxidation reaction even though the electrolyte contains redox pairs, such as iodine/iodide ions, bromine/bromide ions or the like.

One selected from the group consisting of TiO₂, SnO₂, WO₃, ZnO, Nb₂O₅, In₂O₃, ZrO₂, Ta₂O₅, La₂O₃, SrTiO₃ Y₂O₃, Ho₂O₃, Bi₂O₃, CeO₂, and Al₂O₃, or a mixture of two or more selected from the group is preferable as the oxide semiconductor particle. A titanium dioxide fine particle (nanoparticle) is particularly preferable. It is preferable that the average particle size of the titanium dioxide be in the range of about 2 nm to 1000 nm.

A particle having electrical conductivity, such as an electric conductor or a semiconductor, is used as the conductive fine particle.

The specific resistance of the conductive particle is preferably 1.0×10⁻² Ω·cm or less, and more preferably 1.0×10⁻³ Ω·cm or less. Further, the kind, particle size, or the like of the conductive particle is not particularly limited. However, as a material of the conductive particle, there is used a material that is excellently miscible in the electrolyte solution containing ionic liquid as a main material and makes the electrolyte solution gel. Further, it is necessary that the conductive particle does not cause the deterioration of electrical conductivity by forming an oxidized separator (insulating separator) or the like in the electrolyte, and has excellent chemical stability against other accompanying components contained in the electrolyte. In particular, preferable is the conductive particle that does not cause the degradation due to an oxidation reaction even though the electrolyte contains redox pairs, such as iodine/iodide ions, bromine/bromide ions or the like.

As the conductive fine particle, there is a particle that comprises a material containing carbon as a main material. A particle, such as a carbon nanotube, carbon fiber, carbon black or the like, may be exemplified as a specific example of the conductive fine particle. All methods of manufacturing these materials are well known, and products on the market may be used as these material.

As long as being excellent in the adhesion to the substrate 11 of the counter electrode 10 or the base material 21 of the working electrode 20, the sealing member 40 is not particularly limited. As the material of the sealing member 40, there are resins, such as an ionomer, an ethylene-vinyl acetate-anhydride copolymer, an ethylene-methacrylic acid copolymer, an ethylene-vinyl alcohol copolymer, an ultraviolet cured resin, and a vinyl alcohol polymer and the like. Meanwhile, the sealing member 40 may be made of only a resin, and may be made of a resin and inorganic filler. As the above resin, specifically, there are HIMILAN (manufactured by DuPont-Mitsui Polychemicals Co., Ltd.), NUCREL (manufactured by DuPont-Mitsui Polychemicals Co., Ltd.), and the like.

The present invention is not limited to the above-mentioned embodiment. For example, the counter electrode 10 includes the substrate 11 in the above-mentioned embodiment, but the substrate 11 may not necessarily included. For example, if the intermediate layer 12 may be separated from a base material as a self-supported film after being formed by application on the base material, a counter electrode may include the intermediate layer 12 and the separator 14.

Further, in the above-mentioned embodiment, the respective carbon nanotubes 13 of the intermediate layer 12 are disposed so that the longitudinal directions of the carbon nanotubes are mixed to be substantially parallel to one surface 11a of the substrate 11. However, the respective carbon nanotubes 13 may not necessarily need to be disposed so that the longitudinal directions of the carbon nanotubes are mixed to be substantially parallel to one surface 11a of the substrate 11.

### Examples

### <Example 1>

### (Manufacture of electrode substrate)

Single-layer carbon nanotubes having an average diameter of 2 nm were manufactured by thermal CVD method. Further, a solution where the single-layer carbon nanotubes were dispersed was manufactured by mixing the single-layer carbon nanotubes in a solution including 98% sulfuric acid and 60% nitric acid at a ratio of 3:1, and performing ultrasonic treatment for 2 hours. Then, the solution was filtered by filter paper that was made of PTFE and had a thickness of 35 µm, was dried at a temperature of 200°C, and was separated from the filter paper. As a result, a film formed of single-layer carbon nanotubes was obtained. Furthermore, a solution containing 5 wt% of a PTFE copolymer (Nafion, manufactured by DuPont Co., Ltd.) was applied to the film formed of single-layer carbon nanotubes, and was dried at a temperature of 135°C. As a result, an electrode substrate, where a separator made of PTFE and having a thickness of 5 µm was formed in the shape of a film, was manufactured. The electrode substrate was used as a counter electrode of a photoelectric conversion element.

### (Manufacture of electrolyte)

An electrolyte solution, which is made of ionic liquid containing iodine/iodide ion redox pairs, [1-ethyl-3-methylimidazolium (trifluoramethylsulfonyl)imide] was prepared.

### (Manufacture of working electrode)

A glass substrate with a FTO film was used as a transparent electrode substrate, and a slurry-like dispersion aqueous solution of a titanium oxide having an average particle size of 20 nm is applied to the surface of the transparent electrode substrate facing the FTO film (conductive layer). After being dried, the dispersion aqueous solution was heated for 1 hour at a temperature of 450°C. As a result, an oxide semiconductor porous film having a thickness of 7 µm was formed. Further, the substrate was immersed in an ethanol solution of a ruthenium bipyridine complex (N3 dye) for one night so that a dye was supported. As a result, a working electrode was manufactured.

### (Manufacture of cell)

An electrolyte was injected between the working electrode and the counter electrode and then the working electrode and the counter electrode were bonded to each other. As a result, a solar cell was obtained as a solar cell of Example 1.

### <Example 2>

A solar cell was manufactured in the same manner as Example 1 except that multilayer carbon nanotubes having an average diameter of 20 nm were used instead of the single-layer carbon nanotubes when a counter electrode was manufactured. Meanwhile, the multilayer carbon nanotubes were manufactured by using thermal CVD method.

### <Example 3>

A solar cell was manufactured in the same manner as Example 1 except that the powder of a mixture of single-layer carbon nanotubes and multilayer carbon nanotubes was used instead of the single-layer carbon nanotubes when a counter electrode was manufactured. Meanwhile, the same multilayer carbon nanotube as that of Example 2 was used as the multilayer carbon nanotube. Further, a mixing ratio of the multilayer carbon nanotube to the single-layer carbon nanotube was 1:1 in mass.

### <Example 4>

A solar cell was manufactured in the same manner as Example 1 except that carbon black (Ketjen Black EC, manufactured by Ketjen Black International Company) was used instead of the single-layer carbon nanotubes when a counter electrode was manufactured.

### <Example 5>

A solar cell was manufactured in the same manner as Example 1 except that the powder of a mixture of single-layer carbon nanotubes and carbon black (Ketjen Black EC, manufactured by Ketjen Black International Company) was used instead of the single-layer carbon nanotubes when a counter electrode was manufactured. This solar cell was obtained as a solar cell of Example 5. Meanwhile, a mixing ratio of the carbon Black to the single-layer carbon nanotube was 1:1 in mass.

### <Example 6>

A solar cell was manufactured in the same manner as Example 1 except that the thickness of a separator was set to 1 µm when a counter electrode was manufactured.

### <Example 7>

A solar cell was manufactured in the same manner as Example 1 except that the thickness of a separator was set to 3 µm when a counter electrode was manufactured.

### <Example 8>

A solar cell was manufactured in the same manner as Example 1 except that the thickness of a separator was set to 8 µm when a counter electrode was manufactured.

### <Example 9>

A solar cell was manufactured in the same manner as Example 1 except that the thickness of a separator was set to 11 µm when a counter electrode was manufactured.

### <Example 10>

A solar cell was manufactured in the same manner as Example 1 except that the thickness of a separator was set to 16 µm when a counter electrode was manufactured.

### <Example 11>

A solar cell was manufactured in the same manner as Example 1 except that the thickness of a separator was set to 20 µm when a counter electrode was manufactured.

### <Comparative example 1>

A solution where single-layer carbon nanotubes were dispersed was manufactured by mixing the single-layer carbon nanotubes in a solution including 98% sulfuric acid and 60% nitric acid at a ratio of 3:1, and performing ultrasonic treatment for 2 hours. Then, the solution was filtered by filter paper that was made of PTFE and had a thickness of 35 µm, was dried at a temperature of 200°C, and was separated from the filter paper. As a result, a film formed of carbon nanotubes was obtained. A solar cell was manufactured in the same manner as Example 1 except that the film was used as a counter electrode.

### <Photoelectric conversion characteristics>

The photoelectric conversion characteristics of the solar cells of Examples 1 to 11 and Comparative example 1, which were manufactured as described above, were measured. The results are shown in

**[Table 1]**

| | Photoelectric conversion efficiency (%) | Ratio of cells that did not generate electrical power |
|---|---|---|
| Example 1 | 5.1±0.2 | 1 |
| Example 2 | 5.0±0.1 | 2 |
| Example 3 | 5.±0.2 | 1 |
| Example 4 | 3.8±1.0 | 8 |
| Example 5 | 4.0±0.6 | 5 |
| Example 6 | 5.3±0.7 | 4 |
| Example 7 | 5.2±0.3 | 2 |
| Example 8 | 5.1±0.5 | 2 |
| Example 9 | 5.2±0.3 | 2 |
| Example 10 | 5.0±0.3 | 1 |
| Example 11 | 5.0±0.5 | 1 |
| Comparative Example 1 | 4.7±1.5 | 20 |

From Table 1, high photoelectric conversion efficiency of 3.8% or more was observed in Examples 1 to 11 and Comparative example 1 that used the intermediate layer containing carbon nanotubes as the intermediate layer of the counter electrode.

### <Ratio of short circuited cells>

After that, one hundred manufactured solar cells of each of Examples 1 to 11 and Comparative example 1 were prepared, and it was checked whether the working electrodes and the counter electrodes of the solar cells were shortcircuited. A ratio of cells, which did not generate electrical power, was observed. The results are shown in Table 1.

From the results shown in Table 1, electrical power generation was shown in most cells of Examples 1 to 11 where PTTE was disposed on the intermediate layer as a separator. However, a short circuit between the working electrode and the counter electrode occurred in a lot of cells of Comparative example 1 where PTTE was not disposed on the intermediate layer as a separator, and electric power was not generated in 20% of the cells.

According to the present invention, from the above, it has been confirmed that it is possible to achieve the photoelectric conversion element that is excellent in photoelectric conversion efficiency, and a short circuit between the working electrode and the counter electrode hardly occurs by using porous carbon containing carbon nanotubes, which are inexpensive materials having high electrical conductivity as the intermediate layer of the counter electrode and including a separator in the counter electrode.

Further, according to the present invention, it has been confirmed that a solar cell may be easily manufactured.

### INDUSTRIAL APPLICABILITY

The present invention may provide a counter electrode that is excellent in photoelectric conversion efficiency and may achieve a photoelectric conversion element where a short circuit between a working electrode and a counter electrode hardly occurs, and a photoelectric conversion element including the counter electrode.

## Claims

1. A counter electrode comprising:
an intermediate layer comprising porous carbon; and
an insulating separator that is disposed on one surface of the intermediate layer,
wherein the porous carbon includes a plurality of carbon nanotubes.

2. The counter electrode according to claim 1, wherein the counter electrode is used as a counter electrode of a photoelectric conversion element that includes at least a counter electrode, a working electrode disposed so as to face the counter electrode and including an oxide semiconductor porous layer on which a sensitized dye is supported, and an electrolyte that is disposed in at least a part of a gap between the counter electrode and the working electrode.

3. The counter electrode according to claim 1, wherein the intermediate layer is partially exposed through the separator.

4. The counter electrode according to claim 3, further comprising:
a substrate,
wherein the intermediate layer is disposed on one surface of the substrate.

5. The counter electrode according to claim 4, wherein the respective longitudinal directions of the plurality of carbon nanotubes are substantially parallel to one surface of the substrate.

6. The counter electrode according to any one of claims 1 to 5,
wherein the separator is made of a polytetrafluoroethylene copolymer.

7. The counter electrode according to any one of claims 1 to 6,
wherein the carbon nanotube is a single-layer carbon nanotube and/or a multilayer carbon nanotube.

8. A photoelectric conversion element comprising:
a counter electrode according to any one of claims 1 to 7;
a working electrode that is disposed so as to face the counter electrode, and includes an oxide semiconductor porous layer on which a sensitized dye is supported; and
an electrolyte that is disposed in at least a part of a gap between the counter electrode and the working electrode,
wherein the separator is disposed between the intermediate layer of the counter electrode and the electrolyte.
